# EUROPEAN PATENT APPLICATION

(11) **EP 4 748 621 A1**
(43) Veröffentlichungstag der Anmeldung: **27.05.2026**
(21) Anmeldenummer: 25215551.0
(22) Anmeldetag: 13.11.2025
(51) Int. Cl.: B60L 3/00, G01R 31/396, H01M 10/48

(54) **VERFAHREN ZUR OBD-BASIERTEN ERMITTLUNG EINES EINSATZZUSTANDS EINER BATTERIE IN EINEM ZUMINDEST TEILWEISE ELEKTRIFIZIERTEN FAHRZEUG**

(30) Priorität: 20.11.2024 DE 102024134110
(71) Anmelder: MAHLE International GmbH, 70376 Stuttgart (DE)
(72) Erfinder: Ruppricht, Peter, 73732 Esslingen (DE); Storz, Niko, 73262 Reichenbach (DE); Troiani, Mariangelo, 73207 Plochingen (DE); Moser, Michael, 73479 Ellwangen (DE); Ludwig, Lars, 73776 Altbach (DE); Günter, Marcel, 71336 Waiblingen (DE); Kansy, Jessica, 70469 Stuttgart (DE); Loges, André, 71706 Markgröningen (DE); Küchle, Henrike, 73644 Plüderhausen (DE); Wappler, Peter, 70199 Stuttgart (DE)

(57) **Zusammenfassung**

Die vorliegende Erfindung betrifft Verfahren zur Ermittlung eines Einsatzzustands einer Batterie (104) eines zumindest teilweise elektrifizierten Fahrzeugs (100), umfassend Erhalten von On-Board-Diagnose-Messdaten, OBD-Messdaten, des Fahrzeugs (100) über eine erste Kommunikationsschnittstelle (20), wobei die OBD-Messdaten während eines elektrisch angeregten Zustandes der Batterie (104) erzeugt sind; Auswerten der OBD-Messdaten, um einen Parameterdatensatz zu zumindest einem Betriebsparameter der Batterie (104) zu erzeugen; Ermitteln einer Zustandskennzahl der Batterie (104) aus dem Parameterdatensatz, wobei die Zustandskennzahl einen Einsatzzustand der Batterie (104) charakterisiert. Die vorliegende Erfindung betrifft zusätzlich ein Steuersystem (10) zum Ausführen des Verfahrens sowie ein zumindest teilweise elektrifiziertes Fahrzeug (100) mit einem solchen Steuersystem (10).

## Beschreibung

Die vorliegende Erfindung betrifft das Gebiet der Elektromobilität. Insbesondere betrifft die Erfindung ein Verfahren zur Ermittlung eines Einsatzzustands einer Batterie in einem zumindest teilweise elektrifizierten Fahrzeug.

Elektrische Achsantriebe für Reinelektrofahrzeuge und Hybridelektrofahrzeuge sind aus dem Stand der Technik hinreichend bekannt. Derartige Antriebssysteme umfassen in der Regel einen Elektromotor, der mit einer Batterie, etwa Lithium-Ionen-Batterie, angetrieben wird. Die Batterie ist in der Regel als Batteriesystem aus einer Vielzahl von miteinander verbundenen Batteriezellen ausgebildet. Die Batterie stellt eine DC-Spannung bereit, die mittels eines DC/AC-Wechselrichters in eine AC-Spannung zur Erzeugung von AC-Phasenströmen umgewandelt wird. Die AC-Phasenströme werden in Statorwicklungen eingespeist, um im Stator ein magnetisches Drehfeld zu generieren, welches den ebenfalls magnetisch wirkenden Rotor in Rotation versetzt.

Für die Funktionalität des Elektrofahrzeugs ist der Einsatzzustand der Batterie maßgeblich. Somit besteht die Notwendigkeit, den Einsatzzustand der Batterie zu überwachen, um rechtzeitig auf mögliche Fehlersituationen oder Anomalien zu reagieren. Aus dem Stand der Technik ist bekannt, dies mittels Ladestationen bzw. Ladesäulen zu verwirklichen, indem Daten über Batterien, die an den Ladestationen aufgeladen werden/worden sind, hinsichtlich Betriebsparameter der Batterie analysiert werden. Derartige Verfahren sind nicht nur mit einem vergleichsweise komplexen Datenkommunikationsnetzwerk verbunden, sondern auch aufgrund der involvierten Datenschnittstellen fehler- und sicherheitsanfällig.

Die Aufgabe der vorliegenden Erfindung besteht daher darin, ein Verfahren zur Ermittlung eines Einsatzzustands einer Batterie in einem zumindest teilweise elektrifizierten Fahrzeug bereitzustellen, bei dem die vorstehend genannten Nachteile zumindest teilweise überwunden werden.

Die oben genannte technische Aufgabe wird durch ein Verfahren, ein Steuersystem, ein zumindest teilweise elektrifiziertes Fahrzeug sowie ein computerlesbares Speichermedium gemäß dem Hauptanspruch bzw. den nebengeordneten Ansprüchen gelöst. Vorteilhafte Ausführungsformen sind Gegenstand der abhängigen Ansprüche. Die im Zusammenhang mit den auf das Verfahren gerichteten Ansprüchen beschriebenen Vorteile finden ebenfalls Geltung für das erfindungsgemäße Steuersystem, das erfindungsgemäße Fahrzeug sowie das erfindungsgemäße Speichermedium.

Die vorliegende Erfindung betrifft in einem ersten Aspekt ein Verfahren zur Ermittlung eines Einsatzzustands einer Batterie in einem zumindest teilweise elektrifizierten Fahrzeug. Das Fahrzeug umfasst einen elektrischen Achsantrieb, welcher einen Elektromotor und einen Wechselrichter aufweist. Der Elektromotor wird mit einer DC-Spannung angetrieben, die die Batterie erzeugt. Insbesondere wird die DC-Spannung mittels des Wechselrichters in eine AC-Spannung umgewandelt, mit der mehrere AC-Phasenströme erzeugt werden. Die AC-Phasenströme werden in als Statorwicklungen ausgebildete Phasenstränge des Elektromotors eingespeist. Dies bewirkt im Stator ein rotierendes Magnetfeld bzw. Drehfeld, welches einen magnetischen Rotor in Drehbewegung versetzt und den Elektromotor auf diese Weise antreibt.

In einem ersten Verfahrensschritt werden On-Board-Diagnose-Messdaten, OBD-Messdaten, erhalten. Die OBD umfasst Messungen (OBD-Messungen) am Fahrzeug, die mittels eines OBD-Systems aufweisend mehrere Sensoren, Peripheriegeräte und Kommunikationsschnittstellen insbesondere im Fahrbetrieb des Fahrzeugs durchgeführt werden bzw. worden sind. Die Sensoren sind jeweils zur Erfassung eines bestimmten Parameters des Fahrzeugs, insbesondere der verschiedenen im Fahrzeug verbauten Komponenten, ausgebildet. Die OBD-Messdaten werden/wurden erzeugt, während sich die Batterie in einem elektrisch angeregten Zustand befindet. Die OBD-Messdaten betreffen beispielsweise einen Ladezustand (State of Charge, SOC), eine Temperatur, ein Coulomb-Counting (CC-Daten), einen oder mehrere frühere Lade- und/oder Entladeprozesse, einen Strom und/oder eine Spannung der Batterie.

In einem weiteren Verfahrensschritt werden die erhaltenen OBD-Messdaten ausgewertet, um einen Parameterdatensatz zu zumindest einem Betriebsparameter der Batterie zu erzeugen. Der zumindest eine Betriebsparameter umfasst eine Kapazität, einen Innenwiderstand der Batterie. Derartige Größen lassen sich beispielsweise mittels Coulomb-Counting (insbesondere Refined Coulomb-Counting) aus den OBD-Messdaten, insbesondere dem Ladezustand der Batterie, gewinnen. Alternativ oder zusätzlich lassen sich Kapazitäten und/oder Innenwiderstände der einzelnen Batteriemodule und/oder Batteriezellen aus den OBD-Messdaten unmittelbar extrahieren. Insbesondere können die OBD-Messdaten nach ihrer Sensorzugehörigkeit unterteilt werden, um jedem Sensor einen eigenen Parameterdatensatz zuzuordnen. Jeder Parameterdatensatz enthält Werte zu einem bestimmten Parameter. Diejenigen Parameterdatensätze, die den Einsatzzustand bzw. Betriebsparameter der Batterie betreffen oder deren Relevanz zum Einsatzzustand der Batterie eine vordefinierte Relevanzschwelle überschreitet, werden aus den insgesamt gewonnenen Parameterdatensätzen selektiert, woraus mehrere jeweils einem Batterie-Betriebsparameter zugeordnete Parameterdatensätze folgen. Alternativ können die OBD-Messdaten zunächst nach ihrer Relevanz zum Einsatzzustand der Batterie vorselektiert werden. Bspw. werden nur diejenigen OBD-Messdaten, deren Relevanz zum Einsatzzustand der Batterie eine vordefinierte Relevanzschwelle überschreitet, vorselektiert. Die vorselektierten OBD-Messdaten werden anschließend nach ihrer Sensorzugehörigkeit unterteilt, woraus mehrere jeweils einem Batterie-Betriebsparameter zugeordnete Parameterdatensätze folgen. Weiter alternativ können zum Einsatzzustand der Batterie relevante Parameterdatensätze (Endparameterdatensätze) durch Weiterverarbeitung der wie vorstehend beschrieben gewonnenen Parameterdatensätze (Rohparameterdatensätze) erhalten werden, etwa um Messfehler und Messungenauigkeiten zu beseitigen, und/oder aus den Rohparameterdatensätzen, die den/die Betriebsparameter der Batterie nur indirekt betreffen, durch geeignete Rechenschritte den/die Betriebsparameter der Batterie direkt betreffende Endparameterdatensätze zu generieren.

Bevorzugt kann die so-bestimmte Kapazität der Batterie (d.h. der so-erzeugte Parameterdatensatz zur Kapazität der Batterie) einer Referenzkapazität (bzw. einem entsprechenden Datensatz) gegenübergestellt und damit verglichen werden ("Mapping"). Auf diese Weise können temperaturbezogene Variationen und/oder Alterung der Kapazität berücksichtigt werden.

Im einem weiteren Verfahrensschritt wird aus dem zumindest einen Parameterdatensatz eine Zustandskennzahl der Batterie ermittelt, die den Einsatzzustand der Batterie charakterisiert. Als Zustandskennzahl kann eine Restreichweite, insbesondere eine theoretische Restreichweite (TRR, bzw. "Remaining Useful Life, RUL"), der Batterie, beispielsweise aus dem Parameterdatensatz/den Parameterdatensätzen zum Innenwiderstand bzw. zu den Innenwiderständen der Batterie, ermittelt werden. Die TRR- bzw. RUL-Ergebnisse der Batterie enthalten bevorzugt eine Abschätzung über einen zukünftigen Zeitpunkt, in dem eine kritische Kapazitätsschwelle (die etwa 80% der anfänglichen bzw. vollständigen Kapazität entspricht) erreicht wird. Auch ist es denkbar, dass ein Kapazitätsungleichgewicht zwischen den verschiedenen Batteriemodulen und/oder den verschiedenen Batteriezellen basierend auf den OBD-Messdaten, insbesondere den extrahierten Kapazitätswerten der einzelnen Batteriemodule bzw. Batteriezellen, erhalten wird. Weitere Zustandskennzahlen umfassen einen Überladungsgrad und/oder einen Thermal Runaway-Grad und/oder einen weiteren Gesundheitszustandskennzahl (State of Health, SOH) und/oder die Kapazität in Abhängigkeit von der Temperatur (bzw. Einem spezifischen Kapazitätswert bei einer gegebenen Temperatur) der Batterie.

Die so ermittelte Zustandskennzahl der Batterie kann schließlich über eine Kommunikationsschnittstelle ausgegeben werden. Die Kommunikationsschnittstelle kann zum Beispiel das Steuersystem mit der zentralen Steuereinheit des Fahrzeugs, insbesondere der elektronischen Steuereinheit (Electronic Control Unit, ECU), verbinden, um die Zustandskennzahl(en) zwecks Erzeugung von weiteren Steuersignalen an die ECU bereitzustellen.

Auf diese Weise kann beim Detektieren einer Anomalie in der ermittelten Zustandskennzahl eine Gegenmaßnahme zur Vermeidung von Beeinträchtigungen der Batterie bzw. des Fahrzeugs insgesamt rechtzeitig und wirksam ergriffen werden. Erfindungsgemäß wird daher ein intelligentes Batterieanalyse und - diagnoseverfahren bewerkstelligt. Ein Zugriff auf zusätzliche Sensorik ist somit nicht erforderlich, um den Einsatzzustand der Batterie zu bestimmen. Insbesondere entfällt hierdurch die Notwendigkeit, Daten von Ladestationen bzw. Ladesäulen herzuziehen und zu analysieren, sodass die Anzahl der involvierten Datenschnittstellen reduziert wird. Dies führt zur erhöhten Sicherheit und Fehlerbeständigkeit der Batterieanalyseund Diagnose.

Gemäß einer bevorzugten Ausführungsform wird in einem den obigen Verfahrensschritten vorgeschalteten Verfahrensschritt des erfindungsgemäßen Verfahrens zunächst der elektrisch angeregte Zustand der Batterie hergestellt. Alternativ oder zusätzlich werden in einem weiteren vorgeschalteten Verfahrensschritt des erfindungsgemäßen Verfahrens die OBD-Messungen durchgeführt, während sich die Batterie im elektrisch angeregten Zustand befindet, um die OBD-Messdaten zu generieren.

Gemäß einer weiteren bevorzugten Ausführungsform wird in einem den obigen Verfahrensschritten nachgeschalteten Verfahrensschritt des erfindungsgemäßen Verfahrens die ermittelte Zustandskennzahl an eine externe Entität, etwa ein Anzeigegerät (beispielsweise der Touch-Screen eines Mobilgerätes wie Smartphone oder Tablett, oder der Touch-Screen des Fahrzeugs), ausgegeben.

Im Rahmen der vorliegenden Erfindung wird das Steuersystem zur Ermittlung des Einsatzzustands der Batterie des zumindest teilweise elektrifizierten Fahrzeugs vorgeschlagen, wobei das Steuersystem dazu ausgebildet ist, das Verfahren nach einem der hierin beschriebenen Ausführungsformen auszuführen. Das Steuersystem umfasst eine erste Kommunikationsschnittstelle zum Erhalten der OBD-Messdaten, ein Auswertemodul zum Auswerten der OBD-Messdaten und Erzeugen des Parameterdatensatzes/der Parameterdatensätze, ein Ermittlungsmodul zum Ermitteln der Zustandskennzahl basierend auf dem Parameterdatensatz/den Parameterdatensätzen.

Im Rahmen der vorliegenden Erfindung wird ein zumindest teilweise elektrifiziertes Fahrzeug umfassend das erfindungsgemäße Steuersystem vorgeschlagen. Das zumindest teilweise elektrifizierte Fahrzeug kann bspw. ein reinelektrisches Fahrzeug (EV), etwa ein Batterie-Elektrofahrzeug (BEV), oder ein Hybrid-Elektrofahrzeug (HEV) sein. Im Rahmen der vorliegenden Erfindung wird außerdem ein computerlesbares Speichermedium umfassend Befehle vorgeschlagen, die bei der Ausführung durch einen Computer diesen veranlassen, die Schritte des Verfahrens nach einer der im Rahmen dieser Offenbarung beschriebenen Ausführungsformen auszuführen.

Gemäß einer beispielhaften Ausführungsform werden zur Erzeugung des Parameterdatensatzes zum zumindest einen Betriebsparameter der Batterie ausschließlich die OBD-Messdaten ausgewertet. Alternativ oder zusätzlich wird zur Ermittlung der Zustandskennzahl der Batterie ausschließlich der erzeugte Parameterdatensatz herangezogen. Auf diese Weise wird ein intelligentes Batterieanalyse und -diagnoseverfahren bewerkstelligt, bei dem ausschließlich OBD-Messdaten herangezogen werden. Dies führt zu einer weiteren Reduzierung der Anzahl der involvierten Datenschnittstellen und damit einhergehend zu einer weiteren Erhöhung der Sicherheit und Fehlerbeständigkeit der Batterieanalyse- und Diagnose. Außerdem minimiert diese Maßnahme den Datenverarbeitungsaufwand und vereinfacht das erfindungsgemäße Verfahren. Insbesondere werden keine Daten aus fahrzeugexternen Datenquellen wie die Ladeeinrichtung zwecks Ermittlung des Einsatzzustands der Batterie ausgewertet, sodass eine Fortpflanzung von Datenfehlern aus fahrzeugexternen Fehlerquellen wie die Ladeeinrichtung gänzlich ausgeschlossen wird. Zusätzlich wird vermieden, dass der zwecks Batterieanregung eingestellte Strom insbesondere bei höheren Ladeleistungen stark und unregelmäßig aufgrund der fortlaufenden Datenkommunikation zwischen der externen Ladeeinrichtung und der Ladesteuereinheit des Fahrzeugs variiert. Dies erhöht die Stabilität des elektrisch angeregten Zustands der Batterie und somit die Wiederholbarkeit und -genauigkeit der Batteriediagnose und/oder -analyse.

Gemäß einer weiteren beispielhaften Ausführungsform wird der elektrisch angeregte Zustand der Batterie mit Hilfe eines Ladezykluses und/oder eines Entladezykluses der Batterie hergestellt. Der Ladezyklus und/oder der Entladezyklus weist eine Maximaldauer von vorzugsweise 15 Minuten, weiter vorzugsweise 10 Minuten, weiter vorzugsweise 5 Minuten auf. Der Ladezyklus bzw. Entladezyklus wird vorzugsweise durch die Ladeeinrichtung, an die die Batterie angeschlossen ist, bereitgestellt. Bei der Ladeeinrichtung kann es sich um eine AC- und/oder DC-Ladeeinrichtung, eine On-Board-Ladeeinrichtung (On-Board-Charger, OBC) oder eine Wallbox handeln. Vorzugsweise stellt die Ladeeinrichtung auf ein Triggersignal des Steuersystems hin den Ladezyklus und/oder den Entladezyklus bereit. Für den beispielhaften Fall der Wallbox kann das Triggersignal auf der Benutzeroberfläche (User Interface, UI), welche auf dem Anzeigeelement (etwa Touchscreen) des Mobilgerätes bereitgestellt wird, erzeugt werden, indem ein hierfür vorgesehenes virtuelles Kontrollelement wie eine virtuelle Triggertaste oder ein virtueller Triggerknopf auf dem Anzeigeelement bzw. Touchscreen berührend bestätigt wird. Hierdurch lässt sich die Batterie auf vereinfachte und zugleich sichere Weise elektrisch anregen, sodass die Batterieanalyse und -diagnose erleichtert ist.

Gemäß einer weiteren beispielhaften Ausführungsform erfolgt die Auswertung der OBD-Messdaten und/oder die Ermittlung der Zustandskennzahl unter Verwendung eines algorithmischen Modells, vorzugsweise eines neuronalen Netzwerkmodells (NN-Modells), insbesondere eines Machine-Learning-Modells (ML-Modells). Die OBD-Messdaten, insbesondere betreffend den SOC, die Temperatur, das Coulomb-Counting (CC-Daten), den früheren Lade- und/oder Entladeprozess, den Strom und/oder die Spannung der Batterie, werden ins algorithmische Modell, insbesondere das NN- bzw. ML-Modell, eingegeben. Vorzugsweise erzeugt das Modell hierauf basierend die aktuelle Kapazität der Batterie, wobei das Modell ferner vorzugsweise die aktuelle Kapazität einer vorbestimmten Referenzkapazität gegenüberstellt, um einen Vergleich und/oder ein "Mapping" durchzuführen. Das Modell ist vorzugsweise vortrainiert und validiert. Des Weiteren ermittelt das algorithmische Modell, insbesondere das NN- bzw. ML-Modell, aus der Kapazität und/oder dem Innenwiderstand den Gesundheitszustand (SOH).

Gemäß einer bevorzugten Ausführungsform umfasst das algorithmische Modell bzw. das NN-/ML-Modell ein Datenbereinigungsmodul, welches dazu ausgebildet ist, die OBD-Messdaten um ungültige Daten (bzw. Datenpunkte) zwecks Sicherstellung der Datenqualität zu bereinigen. Dazu ist das algorithmische Modell bzw. das NN-/ML-Modell beispielsweise dazu ausgebildet, SOC-Unregelmäßigkeiten wie Diskontinuitäten und/oder übersprungene SOC-Messschritte ("SOC steps") aus den OBD-Messdaten zu detektieren und optional zu entfernen. Alternativ oder zusätzlich ist das algorithmische Modell bzw. das NN-/ML-Modell dazu ausgebildet, Datenpunkte, bei denen das Messzeitintervall (d.h. das Zeitintervall zwischen zwei aufeinanderfolgenden Messungen) zu vernachlässigen.

Gemäß einer weiteren bevorzugten Ausführungsform umfasst das algorithmische Modell ein Vorprozessierungsmodul, um die bereits um ungültige Daten bzw. Datenpunkte bereinigten OBD-Messdaten vorzuprozessieren. Die Vorprozessierung dient beispielsweise dazu, (übrig gebliebene) fehlerbehaftete Datenpunkte zu beseitigen und/oder die OBD-Messdaten auf die Eingabe in ein Machine-Learning-Modul (ML-Modul) vorzubereiten (d.h. das ML-Modul ist ein weiteres Modul des gesamten ML-Modells). Alternativ oder zusätzlich ist das Vorprozessierungsmodul dazu ausgebildet, Pulsmessungen ("pulse measurements") durchzuführen, um sogenannte "virtuel edges" zu erzeugen, die zur Extraktion von Schlüsselmerkmalen verwendet werden, die auf den Gesundheitszustand der Batterie hinweisen.

Gemäß einer bevorzugten Ausführungsform ist das ML-Modell als ein "gemischtes" bzw. kombiniertes ML-Modell ausgebildet, welches mehrere Sub-ML-Modelle umfasst. Diese Maßnahme erhöht die Genauigkeit der Batteriediagnose und/oder - prognose. Beispielsweise kann eines der Sub-ML-Modelle ein erstes Schätzer-Modell umfassen, welches einen zukünftigen Zeitpunkt abschätzt, bei dem die Batteriekapazität auf 80% ihres anfänglichen Wertes bzw. ihres Gesamtwertes fallen und somit den sogenannten C80-Zustand erreichen wird. Diese Schätzung dient somit als ein Indikator für die Restlebensdauer der Batterie. Alternativ oder zusätzlich kann eines der Sub-ML-Modelle ein zweites Schätzer-Modell umfassen, welches die Alterungsrate der Batterie für Fahrzeuge abschätzt, bei denen der C80-Zustand noch nicht erreicht ist. Eine Zusammenführung der beiden obigen Sub-ML-Modelle ist dazu in der Lage, eine besonders zuverlässige SOH-Vorhersage unabhängig von aktuellem Fahrzeugzustand und verfügbaren Daten zu treffen.

Gemäß einer weiteren bevorzugten Ausführungsform ist das ML-Modell zum Transferlernen ("transfer learning") ausgebildet. Mittels des Transferlernens ist das ML-Modell dazu in der Lage, basierend auf eingegebenen OBD-Messdaten eines ersten Fahrzeug- und/oder Batterietyps einen oder mehrere Parameterdatensätze (etwa betreffend Kapazität und/oder Innenwiderstand) eines zweiten Fahrzeugund/oder Batterietyps zu generieren. Dies erfolgt vorzugsweise dadurch, dass der Fahrzeug- und/oder Batterietyp als einer der Parameter ins zum Transferlernen trainierte ML-Modell eingegeben wird (bzw. dass die ersten und zweiten Fahrzeugund/oder Batterietypen ins zum Transferlernen trainierte ML-Modell eingegeben werden). Das ML-Modell ist insbesondere durch das Trainieren auf Transferlernen dazu ausgebildet, eine Anpassung der Parameterdatensätze des ersten Fahrzeugund/oder Batterietyps basierend auf einen Unterschied zwischen beiden Fahrzeug- bzw. Batterietypen durchzuführen. Dazu kann eine Look-Up-Table (LUT) oder eine andere Datenbank herangezogen werden, in der Anpassungsfaktoren zwischen dem ersten Fahrzeug- bzw. Batterietyp und dem zweiten Fahrzeug- bzw. Batterietyp vordefiniert sind. Auf diese Weise ist möglich, eine Analyse und/oder Diagnose der aktuellen Batterie mit hinreichender Genauigkeit durchzuführen, selbst wenn lediglich auf einen von der aktuellen Batterie verschiedenen Batterietypen bezogene und somit limitierte OBD-Messdaten verfügbar sind.

Gemäß einer weiteren bevorzugten Ausführungsform ist das ML-Modell dazu ausgebildet, eine Wahrscheinlichkeitslogik ("probabilistic logic" oder "probabilistic reasoning") zu involvieren. Die Wahrscheinlichkeitslogik wird insbesondere dazu verwendet, Konfidenzintervalle hinsichtlich der erzeugten Parameterdatensätze (etwa betreffend Kapazität und/oder Innenwiderstand), insbesondere durch Berücksichtigung von Unsicherheiten bzw. Toleranzen in den OBD-Messdaten und/oder im ML-Modell zu ermitteln. Hierzu werden bevorzugt Bayesianische neuronale Netzwerke eingesetzt, die basierend auf der Qualitäts- und/oder Vollständigkeitsstufe der OBD-Messdaten Einsichten in die Unsicherheit der Vorhersage über die Restlebensdauer der Batterie bieten und für eine solche Vorhersage somit besonders geeignet sind.

Gemäß einer weiteren bevorzugten Ausführungsform ist das algorithmische Modell, insbesondere das NN- bzw. ML-Modell, mit einem Feedback-Mechanismus ausgestattet, um die Erzeugung der Parameterdatensätze, die Ermittlung der Zustandskennzahl und/oder eine Alterungsprognose kontinuierlich hinsichtlich Genauigkeit zu optimieren. Der Feedback-Mechanismus kann alternativ oder zusätzlich dazu ausgestaltet sein, das ML-Modell anhand von realen Daten ("Real World Data") bzw. basierend auf Vergleichsergebnisse mit realen Daten anzupassen, wobei das ML-Modell optional mit Parameterdatensätzen (etwa betreffend Kapazität und/oder Innenwiderstand der Batterie), die mit dem angepassten ML-Modell gewonnen sind, erneut zu trainieren.

Gemäß einer weiteren beispielhaften Ausführungsform wird eine Quereinflussinformation bei der Auswertung der OBD-Messdaten berücksichtigt. Dies bedeutet, dass der Parameterdatensatz zum zumindest einen Betriebsparameter der Batterie basierend auf den OBD-Messdaten und zusätzlich der Quereinflussinformation erzeugt wird. Alternativ oder zusätzlich wird die Quereinflussinformation bei der Ermittlung der Zustandskennzahl berücksichtigt. Dies bedeutet, dass die Zustandskennzahl basierend auf dem Parameterdatensatz und zusätzlich der Quereinflussinformation ermittelt wird. Die Quereinflussinformation umfasst zumindest eine der folgenden Informationen: eine Temperatur und/oder eine Temperaturverteilung der Batterie und/oder des Fahrzeugs, eine Fahrzeugmodellinformation des Fahrzeugs, eine Laufleistung/ein Kilometerstand des Fahrzeugs, ein geografischer Standort des Fahrzeugs, vorbestimmte Alterungswerte wie Alterungsrate der Batterie, OBD-Messdaten vergleichbarer Batterietypen, Temperaturänderungen/-schwankungen während der OBD-Messung, ein und/oder ein Batteriemanagementsystem(BMS)-Parameter. Die Berücksichtigung der Quereinflussinformation bei der Erzeugung des zumindest einen Parameterdatensatzes kann erfolgen, indem der erzeugte Parameterdatensatz bzw. die erzeugten Parameterdatensätze basierend auf der Quereinflussinformation korrigiert wird/werden. Alternativ können die OBD-Messdaten und die Quereinflussinformation in Kombination dem zumindest einem Parameterdatensatz zugrunde gelegt werden. Durch die Berücksichtigung der Quereinflussinformation(en) kann der zumindest eine Parameterdatensatz zum Betriebsparameter der Batterie und/oder die Zustandskennzahl der Batterie mit höherer Präzision bereitgestellt werden. Die Batterieanalyse und -diagnose wird somit zuverlässiger.

Gemäß einer weiteren beispielhaften Ausführungsform erfolgt die Berücksichtigung der Quereinflussinformation unter Verwendung des NN- bzw. ML-Modells. Beispielsweise kann der erzeugte Parameterdatensatz und die Quereinflussinformation in das NN-Modell bzw. das ML-Modell eingegeben, um einen korrigierten bzw. angepassten Parameterdatensatz zu erzeugen. Alternativ können OBD-Messdaten und die Quereinflussinformation ins NN-Modell bzw. ML-Modell eingegeben werden, um einen die Quereinflussinformationen berücksichtigenden Parameterdatensatz zum zumindest einen Betriebsparameter zu erzeugen. Das NN-Modell bzw. ML-Modell ist vorzugsweise mit Trainingsdaten, die die verschiedenen Arten von Quereinflussinformationen betreffen, vortrainiert. Es kann sich hierbei insbesondere um ein Large-Language-Modul (LLM-Modul) des gesamten NN- bzw. ML-Modells handeln, das dazu trainiert wurde, aus einer teilweise oder vollständig semantischen Aufgabenbeschreibung einen vorgespeicherten Datensatz betreffend eine Quereinflussinformation aus einem geeigneten Speichermedium zu extrahieren, und die OBD-Messdaten bzw. den zumindest einen Parameterdatensatz basierend auf der Quereinflussinformation anzupassen. Ein solches LLM umfasst mehrere Neuronenschichten, die gemäß einer Transformer-Architektur mit Encodern und Decodern, vorzugsweise zusätzlich mit einem Selbstaufmerksamkeitsmechanismus, aufgebaut sind. Durch die Verwendung des NN- bzw. des ML-Modells (etwa des LLM-Moduls) können die OBD-Messdaten oder alternativ der aus den OBD-Messdaten erzeugte zumindest eine Parameterdatensatz zum Betriebsparameter der Batterie präziser und effizienter auf die Quereinflussinformation angepasst werden.

Gemäß einer weiteren beispielhaften Ausführungsform umfasst das Verfahren ferner Schätzen eines Alters, einer Alterungsrate und/oder einer Restlebensdauer ("Remaining Useful Life", RUL) der Batterie basierend auf der ermittelten Zustandskennzahl. Dies erfolgt vorzugsweise unter Verwendung des algorithmischen Modells, insbesondere des NN-Modells bzw. des ML-Modells. Dazu kann die ermittelte Zustandskennzahl an ein Schätzungsmodul des Steuersystems ausgegeben werden, welches hierauf basierend das Alter, die Alterungsrate und/oder die Restlebensdauer der Batterie berechnet. Hierdurch wird das Resultat der Batterieanalyse- und Diagnose um eine Alterungsprognose erweitert bzw. vervollständigt. Alternativ kann die Alterungsprognose (die Alterungsrate und/oder die Restlebensdauer) direkt aus dem erzeugten Parameterdatensatz bzw. den erzeugten Parameterdatensätzen, insbesondere betreffend die Kapazität und/oder den Innenwiderstand der Batterie, ermittelt werden. Hierbei ist denkbar, Alterungsdaten (etwa Alterungskurven, die jeweils eine zeitliche Funktion der Alterungsrate umfassen) einer externen Batterie, insbesondere eines vergleichbaren oder gleichen Batterietyps, zu berücksichtigen bzw. als zusätzliche Eingabedaten in das NN-Modell bzw. das ML-Modell zu integrieren. Dies ermöglicht das Bestimmen einer zukünftigen Entwicklungstrajektorie der Kapazität (insbesondere den Verlauf des Kapazitätsverlustes in zeitlicher Abhängigkeit) und/oder des Innenwiderstands der Batterie. Außerdem ist hierdurch ein direkter Vergleich der Alterungscharakteristik des betroffenen Fahrzeugs mit einer durchschnittlichen Alterungscharakteristik eines vergleichbaren Fahrzeugs (etwa eines vergleichbaren Fahrzeugtyps) ermöglicht, um eventuelle Anomalien der Batterie festzustellen. Die Daten der Alterungsprognose können außerdem als zusätzliche Trainingsdaten zu weiterem Optimieren des NN-Modells bzw. des ML-Modells eingesetzt werden, um die Genauigkeit der Alterungsprognose zu verbessern. Der Zustand, bei dem die Batterie 80% ihrer Gesamtkapazität (bzw. ihrer anfänglichen Kapazität) erreicht wird (d.h. der C80-Zustand) und/oder die Restlebensdauer der Batterie kann beispielsweise mit erhöhter Zuverlässigkeit detektiert/bestimmt werden. Vorzugsweise kann diese Alterungsprognose wahlweise durchgeführt werden, indem nach der Ermittlung der Zustandskennzahl(en) mehrere Optionen zur Verfügung gestellt werden: eine erste Option, bei der keine Alterungsprognose durchgeführt und die ermittelte Zustandskennzahl ausgegeben wird; eine zweite Option, bei der die Alterungsprognose basierend auf der ermittelten Zustandskennzahl durchgeführt wird, wobei das Resultat der Alterungsprognose entweder nach der Ausgabe der Zustandskennzahl oder gleichzeitig dazu ausgegeben wird.

Gemäß einer weiteren bevorzugten Ausführungsform umfasst das Steuersystem ein Triggermodul zum Herstellen des elektrisch angeregten Zustands der Batterie durch die Ladeeinrichtung, und/oder ein Startmodul zum Starten der OBD-Messungen durch das OBD-System. Das Triggermodul ist dazu ausgebildet, die Ladeeinrichtung dahingehend anzusteuern, um den elektrisch angeregten Zustand der Batterie herzustellen. Optional kann das Steuersystem zusätzlich ein Schätzungsmodul zum Schätzen des Alters, der Alterungsrate und/oder der Restlebensdauer basierend auf der Zustandskennzahl/den Zustandskennzahlen umfassen.

Gemäß einer weiteren bevorzugten Ausführungsform ist das Steuersystem zumindest teilweise, vorzugsweise vollständig, auf einem Mobilgerät, beispielsweise einem Smartphone und/oder einem Tablett, welches weiter vorzugsweise einen Touch-Screen aufweist, oder alternativ in einem Fahrzeug oder einem Server, etwa einem Cloud-Server bereitgestellt. Insbesondere kann zumindest eines der o.g. Module und/oder Kommunikationsschnittstelle des Steuersystems auf einer der o. g. Entitäten bereitgestellt sein. Das OBD-System kann, nachdem der elektrisch angeregte Zustand der Batterie stabil hergestellt ist, auf ein Startsignal des Steuersystems hin mit der Durchführung der OBD-Messungen beginnen. Das Startsignal kann auf einer Benutzeroberfläche (User Interface, UI), welche auf einem Anzeigeelement (etwa dem Touch-Screen) des Mobilgerätes oder des Fahrzeugs bereitgestellt wird, erzeugt werden, indem ein hierfür vorgesehenes virtuelles Kontrollelement wie eine virtuelle Starttaste oder ein virtueller Startknopf auf dem Anzeigeelement bzw. Touch-Screen berührend bestätigt wird. Aus diesen OBD-Messungen werden die OBD-Messdaten erzeugt, die typischerweise Werte zu den erfassten Parametern enthalten. Die OBD-Messdaten werden per Peripheriegeräte ausgelesen und über die Kommunikationsschnittstellen an ein Auswertemodul des Steuersystems geführt.

Die oben genannten Aspekte dienen illustrativen Zwecken und sind nicht dazu gedacht, den Umfang der Erfindung einzuschränken. Zahlreiche Variationen der oben beschriebenen Aspekte sind möglich. Die verschiedenen in der vorliegenden Offenbarung diskutierten Aspekte können beliebig kombiniert werden, um zusätzliche Vorteile hervorzubringen. Darüber hinaus können einige der Merkmale die Grundlage für eine oder mehrere Teilanmeldungen bilden.

Die Erfindung wird nachstehend anhand von Beispielen unter Verwendung der in den Figuren gezeigten Ausführungsformen erläutert. Es zeigen:
Fig. 1 eine schematische Darstellung eines zumindest teilweise elektrifizierten Fahrzeugs;
Fig. 2 eine schematische Darstellung einer Anordnung umfassend eine Ladeeinrichtung, ein On-Board-Diagnose (OBD)-System und ein Steuersystem zur Ermittlung eines Einsatzzustands einer Batterie des Fahrzeugs gemäß einer Ausführungsform;
Fig. 3 eine schematische Darstellung einer Anordnung umfassend die Ladeeinrichtung, das OBD-System und das Steuersystem zur Ermittlung des Einsatzzustands der Batterie des Fahrzeugs gemäß einer weiteren beispielhaften Ausführungsform;
Fig. 4 eine schematische Darstellung einer Anordnung umfassend die Ladeeinrichtung, das OBD-System und das Steuersystem zur Ermittlung des Einsatzzustands der Batterie des Fahrzeugs gemäß einer weiteren beispielhaften Ausführungsform;
Fig. 5 eine schematische Darstellung einer Anordnung umfassend die Ladeeinrichtung, das OBD-System und das Steuersystem zur Ermittlung des Einsatzzustands der Batterie des Fahrzeugs gemäß einer weiteren beispielhaften Ausführungsform;
Fig. 6 eine schematische Darstellung einer Anordnung umfassend die Ladeeinrichtung, das OBD-System und das Steuersystem zur Ermittlung des Einsatzzustands der Batterie des Fahrzeugs gemäß einer weiteren beispielhaften Ausführungsform;
Fig. 7 eine schematische Darstellung einer Anordnung umfassend die Ladeeinrichtung, das OBD-System und das Steuersystem zur Ermittlung des Einsatzzustands der Batterie des Fahrzeugs gemäß einer weiteren beispielhaften Ausführungsform;
Fig. 8 eine schematische Darstellung des Steuersystems gemäß einer Ausführungsform;
Fig. 9A eine schematische Darstellung eines Verfahrens zur Ermittlung des Einsatzzustands der Batterie des Fahrzeugs gemäß einer Ausführungsform;
Fig. 9B eine schematische Darstellung eines algorithmischen Modells, welches vorzugsweise als Machine-Learning-Modell, ML-Modell, ausgebildet ist;
Fig. 10 eine schematische Darstellung eines Verfahrens zur Ermittlung des Einsatzzustands der Batterie des Fahrzeugs gemäß einer weiteren beispielhaften Ausführungsform;
Fig. 11 eine schematische Darstellung eines Verfahrens zur Ermittlung des Einsatzzustands der Batterie des Fahrzeugs gemäß einer weiteren beispielhaften Ausführungsform.

Die gleichen Objekte, funktionale Einheiten und vergleichbare Komponenten sind in den Figuren mit denselben Bezugsnummern versehen. Diese Objekte, funktionale Einheiten und vergleichbaren Komponenten sind hinsichtlich ihrer technischen Merkmale identisch, es sei denn, die Beschreibung explizit oder implizit etwas anderes offenbart.

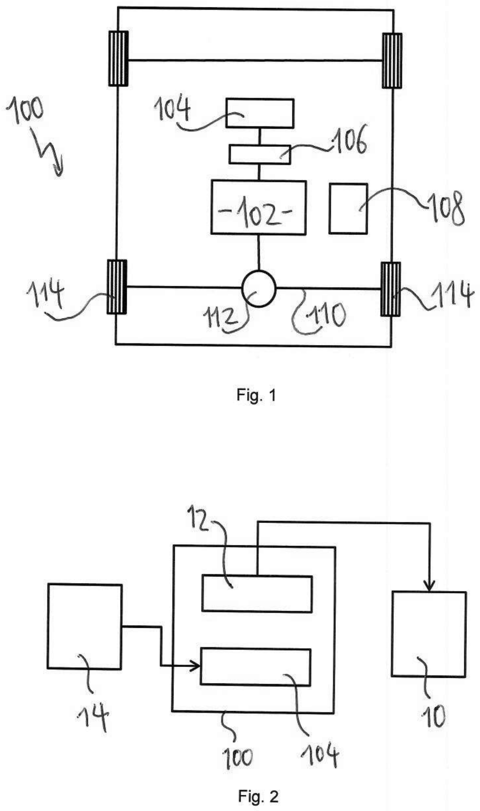

Fig. 1 zeigt eine schematische Darstellung eines zumindest teilweise elektrifizierten Fahrzeugs 100. Das Fahrzeug 100 kann ein reines Elektrofahrzeug oder ein Hybridfahrzeug aufweisen. Das Fahrzeug 100 ist mit einem elektrischen Achsantrieb umfassend einen Elektromotor 102, einen DC/AC-Wechselrichter 106 und ein Getriebe 112 ausgebildet. Der Elektromotor 100 umfasst einen Stator mit mehreren als Statorwicklungen vorliegenden Phasensträngen und einen Rotor, der magnetisch wirkt. Der Wechselrichter 106 ist zwecks Umwandlung einer durch eine Antriebsbatterie 104 bereitgestellten DC-Eingangsspannung in eine AC-Ausgangsspannung zwischen der Antriebsbatterie 104 und dem Elektromotor 102 verschaltet. Dazu weist der Wechselrichter 106 eine Mehrzahl von hier nicht näher gezeigten Leistungsschaltern auf, die eine Brückenschaltung mit mehreren Halbbrücken bilden und mit von einem Steuergerät 108 generierten Steuersignalen ansteuerbar sind. Das Steuergerät 108 kann eine zentrale Steuereinheit, etwa die elektronische Steuereinheit (Electronic Control Unit, ECU) des Fahrzeugs 100 oder ein Bestandteil hiervon sein. Die Steuersignale sind vorzugsweise dazu ausgebildet, die Leistungsschalter des Wechselrichters 106 gemäß einer Pulsweitenmodulation (PWM) zu schalten. Insbesondere werden durch Öffnen und Schließen der Leistungsschalter mehrere vorzugsweise zeitlich sinusförmig verlaufende und voneinander phasenverschobenen Phasenströme je für einen der Phasenstränge erzeugt. Die Phasenströme, die jeweils in eine der mehreren Phasenstränge eingespeist werden, bewirken im Innenbereich des Stators ein rotierendes Magnetfeld, welches den magnetischen Rotor in Drehbewegung versetzt. Auf diese Weise wird ein Drehmoment durch den Elektromotor 102 erzeugt, welches über das Getriebe 112 an eine Achse 110 (hier beispielhaft als Hinterachse vorliegend) und schließlich an Räder 114 (hier beispielhaft als Hinterräder vorliegend) übertragen wird.

Die Antriebsbatterie 104 kann als Lithium-Ionen-Batterie, insbesondere Lithiumtitanat-Akkumulatoren (LTO), Lithium-Cobaltdioxid-Akkumulatoren (LCO), Lithium-Mangan-Akkumulatoren (LMO, LNMO), Lithium-Polymer-Akkumulatoren, Lithium-Eisenphosphat-Akkumulatoren (LFP), Lithium-Luft-Akkumulatoren oder Zinn-Schwefel-Lithium-Ionen-Akkumulatoren ausgebildet sein. Die Antriebsbatterie 104 kann als Batteriesystem umfassend eine Vielzahl von Batteriemodulen ausgebildet sein, wobei jedes Batteriemodul wiederum mehrere Batteriezellen umfasst. Für die Funktionalität des Fahrzeugs 100 ist es wichtig, einen positiven Einsatzzustand der Antriebsbatterie 104 sicherzustellen. Dazu soll eine Batterieanalyse und -diagnose dienen.

Fig. 2 zeigt eine schematische Darstellung eines Steuersystems 10 zur Ermittlung des Einsatzzustands der Antriebsbatterie 104 in Zusammenwirkung mit einem On-Board-Diagnose(OBD)-System 12, welches ins Fahrzeug 100 integriert ist. Das Steuersystem 10 ist vorzugsweise in einem vom Fahrzeug 100 unabhängigen Mobilgerät wie Smartphone oder Tablett (hier nicht gezeigt) realisiert. Das OBD-System 12 umfasst mehrere hier nicht näher gezeigte Sensoren, die jeweils zur Erfassung eines Parameters des Fahrzeugs 100 im Fahrbetrieb ausgebildet sind. Das OBD-System 12 kann unabhängig vom Steuersystem 10 die OBD-Messungen durchführen. Aus diesen OBD-Messungen resultieren OBD-Messdaten, die an das Steuersystem 10 weitergeleitet werden. Des Weiteren ist eine Ladeeinrichtung 14 zur Anregung der Antriebsbatterie 104 an diese angeschlossen. Die Ladeeinrichtung 14 kann zum Beispiel eine AC- und/oder DC-Ladeeinrichtung, eine Ladestation bzw. Ladesäule, eine Wallbox aufweisen. Die Ladeeinrichtung 14 kann unabhängig vom Steuersystem 10 die Antriebsbatterie104 in den elektrisch angeregten Zustand einbringen. Dies kann erfolgen, indem ein Ladezyklus und/oder Entladezyklus der Antriebsbatterie 104 durch die Ladeeinrichtung 14 bereitgestellt wird. Die OBD-Messungen werden durchgeführt, während sich die Antriebsbatterie 104 im elektrisch angeregten Zustand befindet.

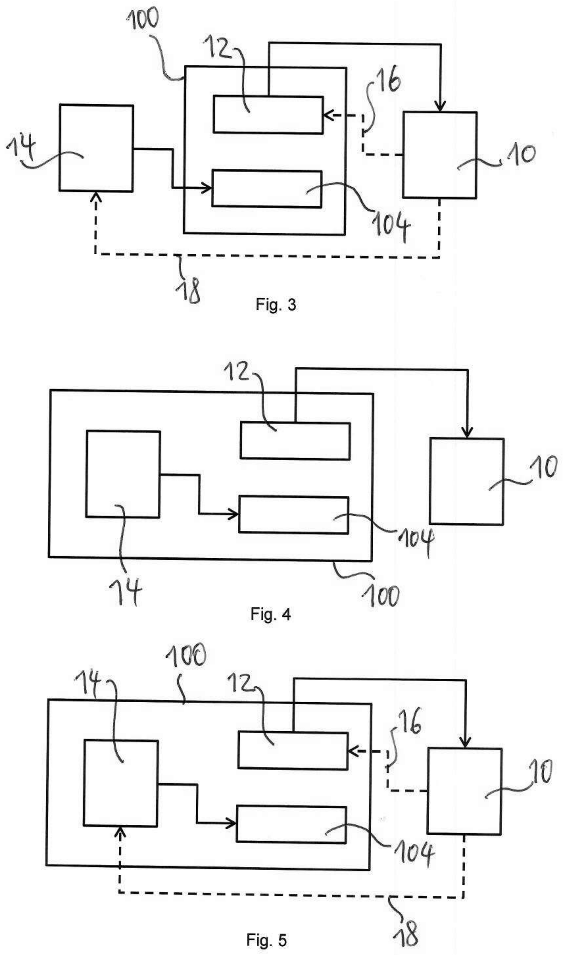

Alternativ kann die Ladeeinrichtung 14 basierend auf einem Triggersignal 18 des Steuersystems 10 die Anregung der Antriebsbatterie 104 bereitstellen. Weiter alternativ oder zusätzlich kann das OBD-System 12 basierend auf einem Startsignal 16 des Steuersystems 10 die OBD-Messungen durchführen. Dies ist in Fig. 3 schematisch und rein beispielhaft gezeigt.

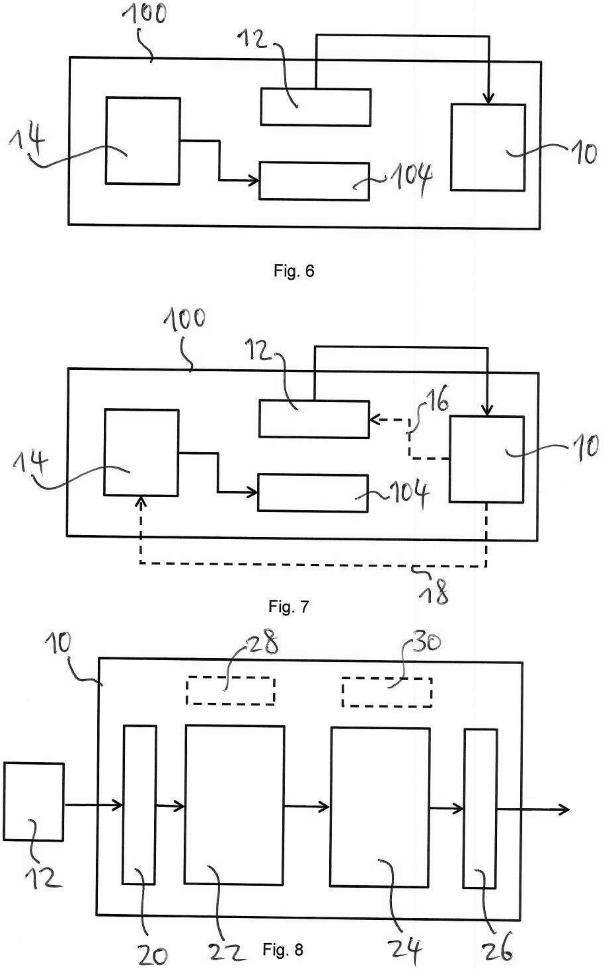

Fig. 4-5 zeigen jeweils eine schematische Darstellung des Steuersystems 10 in Zusammenwirkung mit dem OBD-System 12 und der Ladeeinrichtung 14 in Analogie zur in Fig. 2 bzw. Fig. 3 gezeigten Ausführungsform. Der einzige Unterschied zu den Ausführungsformen aus Fig. 2-3 besteht darin, dass die Ladeeinrichtung 14 als On-Board-Ladeeinrichtung (On-Board-Charger, OBC) ausgebildet ist, welche ins Fahrzeug 100 integriert ist. Fig. 6-7 zeigen jeweils eine schematische Darstellung des Steuersystems 10 in Zusammenwirkung mit dem OBD-System 12 und der Ladeeinrichtung 14 in Analogie zur in Fig. 4 bzw. Fig. 5 gezeigten Ausführungsform. Der einzige Unterschied zu den Ausführungsformen aus Fig. 4-5 besteht darin, dass zusätzlich zur Ladeeinrichtung 14, die hier ebenfalls als On-Board-Ladeeinrichtung (On-Board-Charger, OBC) ausgebildet ist, auch das Steuersystem 10 ins Fahrzeug 100 integriert ist. Hierbei kann das Steuersystem 10 beispielsweise Bestandteil des Steuergeräts 108 (siehe Fig. 1) sein oder mit diesem datenkommunikativ verbunden sein. Die in Fig. 2-7 gezeigten Ausführungsformen sind jedoch für die vorliegende Erfindung nicht einschränkend. Es ist beispielsweise denkbar, das Steuersystem 10 im Fahrzeug 100 zu realisieren, während es sich bei der Ladeeinrichtung 14 um eine extern Ladeeinrichtung handelt.

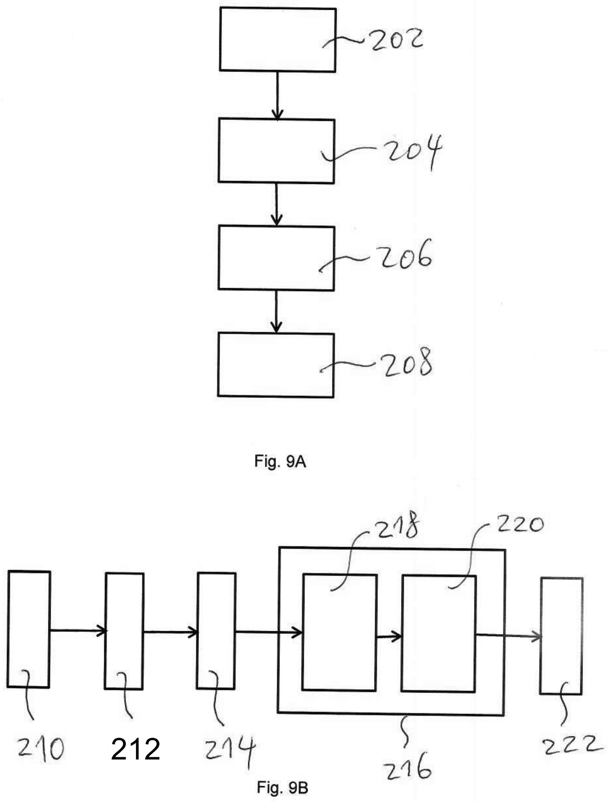

Fig. 8 zeigt eine schematische Darstellung des Steuersystems 10 Gemäß einer weiteren beispielhaften Ausführungsform. Das Steuersystem 10 umfasst eine erste Kommunikationsschnittstelle 20, die als Dateneingang zum Empfangen von OBD-Messdaten des OBD-Systems 12 ausgebildet ist. Ein entsprechender Verfahrensschritt 202 zum Erhalten der OBD-Messdaten ist in Fig. 9A im Zusammenhang mit einem Verfahren zur Ermittlung eines Einsatzzustands der Antriebsbatterie 104 schematisch und rein beispielhaft gezeigt. Die OBD-Messdaten betreffen beispielsweise einen Ladezustand (State of Charge, SOC), eine Temperatur, Coulomb-Counting (CC-Daten), einen oder mehrere frühere Ladeund/oder Entladeprozesse, einen Strom und/oder eine Spannung der Antriebsbatterie 104.

Das Steuersystem 10 umfasst ein Auswertemodul 22 zur Auswertung der OBD-Messdaten (was einem weiteren Verfahrensschritt 204 in Fig. 9A entspricht), wobei das Auswertemodul 22 basierend auf dem Auswertungsergebnis der OBD-Messdaten einen Parameterdatensatz zu zumindest einem Betriebsparameter der Antriebsbatterie 104 erzeugt. Der zumindest eine Betriebsparameter umfasst eine Kapazität, einen Innenwiderstand, einen Ladezustand (State of Charge, SOC), eine Temperatur, ein Strom und/oder eine Spannung der Antriebsbatterie 104. Derartige Größen lassen sich beispielsweise mittels Coulomb-Counting aus den OBD-Messdaten gewinnen. Alternativ oder zusätzlich lassen sich Kapazitäten, Ladezustände, Innenwiderstände, Temperaturen und/oder Spannungen der einzelnen Batteriemodule und/oder Batteriezellen aus den OBD-Messdaten extrahieren. Insbesondere können die OBD-Messdaten nach ihrer Sensorzugehörigkeit unterteilt werden, um jedem Sensor einen eigenen Parameterdatensatz zuzuordnen. Jeder Parameterdatensatz enthält Werte zu einem bestimmten Parameter. Diejenigen Parameterdatensätze, die den Einsatzzustand bzw. Betriebsparameter der Antriebsbatterie 104 betreffen oder deren Relevanz zum Einsatzzustand der Antriebsbatterie 104 eine vordefinierte Relevanzschwelle überschreitet, werden aus den insgesamt gewonnenen Parameterdatensätzen selektiert, woraus mehrere jeweils einem Batterie-Betriebsparameter zugeordnete Parameterdatensätze folgen. Alternativ können die OBD-Messdaten zunächst nach ihrer Relevanz zum Einsatzzustand der Batterie vorselektiert werden (z.B. nur diejenigen OBD-Messdaten, deren Relevanz zum Einsatzzustand der Antriebsbatterie 104 eine vordefinierte Relevanzschwelle überschreitet, werden vorselektiert). Die vorselektierten OBD-Messdaten werden anschließend nach ihrer Sensorzugehörigkeit unterteilt, woraus mehrere jeweils einem Batterie-Betriebsparameter zugeordnete Parameterdatensätze folgen. Weiter alternativ können zum Einsatzzustand der Antriebsbatterie 104 relevante Parameterdatensätze (Endparameterdatensätze) durch Weiterverarbeitung der wie vorstehend beschrieben gewonnenen Parameterdatensätze (Rohparameterdatensätze) erhalten werden, etwa um Messfehler und Messungenauigkeiten zu beseitigen, und/oder aus den Rohparameterdatensätzen, die den/die Betriebsparameter der Antriebsbatterie 104 nur indirekt betreffen, durch geeignete Rechenschritte den/die Betriebsparameter der Antriebsbatterie 104 direkt betreffende
Endparameterdatensätze zu generieren.

Es ist denkbar, bei der Erzeugung des zumindest einen Parameterdatensatzes eine Quereinflussinformation zu berücksichtigen. Die Quereinflussinformation umfasst zumindest eine der folgenden Informationen: eine Temperatur und/oder eine Temperaturverteilung der Antriebsbatterie 104 und/oder des Fahrzeugs 100, eine Fahrzeugmodellinformation des Fahrzeugs 100, eine Laufleistung/ein Kilometerstand des Fahrzeugs 100, ein geografischer Standort des Fahrzeugs 100, vorbestimmte Alterungswerte wie Alterungsrate der Antriebsbatterie 104, OBD-Messdaten vergleichbarer Batterietypen, Temperaturänderungen/-schwankungen während der OBD-Messung(en), und/oder ein Batteriemanagementsystem (BMS)-Parameter.

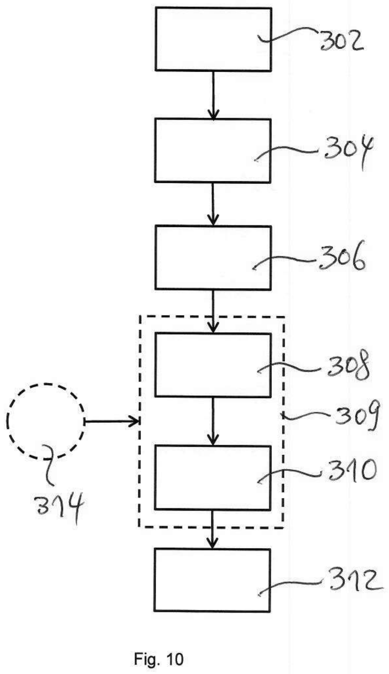

Fig. 10 zeigt eine schematische Darstellung des Verfahrens gemäß einer entsprechenden Ausführungsform. Zusätzlich zu den in Fig. 9A gezeigten Verfahrensschritten 202, 204, 206, 208, welchen die Verfahrensschritte 306, 308, 310, 312 aus Fig. 10 jeweils in einer Eins-zu-Eins-Entsprechung entsprechen, umfasst das in Fig. 10 gezeigte Verfahren einen Verfahrensschritt 302, in dem ein Triggersignal zur elektrischen Anregung der Antriebsbatterie 104 durch ein Triggermodul 28 des Steuersystems 10 (siehe Fig. 8) an die Ladeeinrichtung 14 gesendet wird, sowie einen weiteren Verfahrensschritt 304, in dem ein Startsignal zum Starten und Durchführen der OBD-Messungen durch ein Startmodul 30 des Steuersystems 10 (siehe Fig. 8) ans OBD-System 12 gesendet wird, während sich die Antriebsbatterie 104 im elektrisch angeregten Zustand befindet. Des Weiteren ist dort gezeigt, dass die Quereinflussinformation 314 (hier durch gestrichelten Kreis angedeutet) im dortigen Datenverarbeitungsfluss berücksichtigt wird. Das gestrichelte Rechteck 309 in Fig. 10 deutet an, dass die Quereinflussinformation 314 wahlweise nach dem Verfahrensschritt 308 (d. h. nach dem Empfang der OBD-Messdaten und somit bei der Erzeugung des zumindest einen

Parameterdatensatzes) oder nach dem Verfahrensschritt 310 (d. h. nach der Erzeugung des zumindest einen Parameterdatensatzes und somit bei der Ermittlung der Zustandskennzahl) berücksichtigt wird. Die Berücksichtigung der Quereinflussinformation kann erfolgen, indem die OBD-Messdaten und die Quereinflussinformation in Kombination dem zumindest einem Parameterdatensatz zugrunde gelegt werden. Alternativ oder zusätzlich kann der erzeugte Parameterdatensatz bzw. können die erzeugten Parameterdatensätze basierend auf der Quereinflussinformation korrigiert werden.

Das Steuersystem 10 umfasst ferner ein Ermittlungsmodul 24 zur Ermittlung einer den Einsatzzustand der Antriebsbatterie 104 charakterisierenden Zustandskennzahl aus dem Parameterdatensatz/den Parameterdatensätzen (entsprechend einem weiteren Verfahrensschritt 206 aus Fig. 9A). Die Zustandskennzahl kann eine Restreichweite, insbesondere eine theoretische Restreichweite (TRR), der Antriebsbatterie 104 sein, die aus dem Parameterdatensatz/den Parameterdatensätzen zum Innenwiderstand bzw. zu den Innenwiderständen der Antriebsbatterie bzw. Batteriemodulen/-zellen, ermittelt wird. Auch ist es denkbar, ein Kapazitätsungleichgewicht zwischen den verschiedenen Batteriemodulen und/oder den verschiedenen Batteriezellen basierend auf den extrahierten Kapazitätswerten der einzelnen Batteriemodule bzw. Batteriezellen zu erhalten. Weitere Zustandskennzahlen umfassen einen Überladungsgrad und/oder einen Thermal Runaway-Grad und/oder einen weiteren Gesundheitszustandskennzahl (State of Health, SOH) der Antriebsbatterie 104.

Die Auswertung der OBD-Messdaten und/oder die Ermittlung der Zustandskennzahl erfolgt vorzugsweise unter Verwendung eines algorithmischen Modells, welches beispielsweise ein neuronales Netzwerkmodell (NN-Modell), insbesondere ein Machine-Learning-Modell (ML-Modell) umfasst. Fig. 9A zeigt ein schematisches und beispielhaftes Blockschaltdiagramm des algorithmischen Modells. Das Modell umfasst ein Eingangsmodul 210 zur Eingabe der OBD-Messdaten, insbesondere betreffend den SOC, die Temperatur, das Coulomb-Counting (CC-Daten), den früheren Lade- und/oder Entladeprozess, den Strom und/oder die Spannung der Antriebsbatterie 104. Das Modell umfasst ein Datenbereinigungsmodul 212, welches dazu ausgebildet ist, die OBD-Messdaten um ungültige Daten (bzw. Datenpunkte) zwecks Sicherstellung der Datenqualität zu bereinigen. Dazu ist das Datenbereinigungsmodul 212 insbesondere dazu ausgebildet, SOC-Unregelmäßigkeiten wie Diskontinuitäten und/oder übersprungene SOC-Messschritte ("SOC steps") aus den OBD-Messdaten zu detektieren und zu entfernen. Alternativ oder zusätzlich ist das Datenbereinigungsmodul 212 dazu ausgebildet, Datenpunkte, bei denen das Messzeitintervall (d.h. das Zeitintervall zwischen zwei aufeinanderfolgenden Messungen) zu vernachlässigen. Das Modell umfasst zusätzlich ein Vorprozessierungsmodul 214, um die vom Datenbereinigungsmodul 212 bereitgestellten, bereits um ungültige Daten bzw. Datenpunkte bereinigten OBD-Messdaten vorzuprozessieren. Die Vorprozessierung dient beispielsweise dazu, (übrig gebliebene) fehlerbehaftete Datenpunkte zu beseitigen und/oder die OBD-Messdaten auf die Eingabe in ein Machine-Learning-Modul (ML-Modul) vorzubereiten (d.h. das ML-Modul ist ein weiteres Modul des gesamten ML-Modells). Alternativ oder zusätzlich ist das Vorprozessierungsmodul 214 dazu ausgebildet, Pulsmessungen ("pulse measurements") durchzuführen, um sogenannte "virtuel edges" zu erzeugen, die zur Extraktion von Schlüsselmerkmalen verwendet werden, die auf den Gesundheitszustand der Antriebsbatterie 104 hinweisen.

Des Weiteren umfasst das Modell, welches vorzugsweise als ML-Modell vorliegt, ein Machine-Learning Modul (ML-Modul) 216, welches vortrainiert und optional zusätzlich validiert ist. Das ML-Modul 216 umfasst ein erstes Teilmodul 218 zur Auswertung der OBD-Messdaten, insbesondere der vom Vorprozessierungsmodul 214 bereitgestellten OBD-Messdaten. Das erste Teilmodul 218 liefert hieraus zumindest einen Parameterdatensatz, insbesondere betreffend die Kapazität und/oder den Innenwiderstand der Antriebsbatterie 104. Das ML-Modul 216 umfasst ein zweites Teilmodul 220 zur Ermittlung der Zustandskennzahl, insbesondere des SOH und/oder der Restlebensdauer der Antriebsbatterie 104 aus dem Parameterdatensatz. Das Modell umfasst schließlich ein Ausgangsmodul 222 zur Ausgabe der Zustandskennzahl, optional auch der anderen Datenverarbeitungsergebnisse (etwa der bereinigten und/oder vorprozessierten OBD-Messdaten, des Parameterdatensatzes).

Das ML-Modell und/oder das ML-Modul 216 ist vorzugsweise als ein "gemischtes" bzw. kombiniertes ML-Modell ausgebildet, welches mehrere Sub-ML-Modelle umfasst. Diese Maßnahme erhöht die Genauigkeit der Batteriediagnose und/oder - prognose. Beispielsweise kann eines der Sub-ML-Modelle ein erstes Schätzer-Modell umfassen, welches einen zukünftigen Zeitpunkt abschätzt, bei dem die Batteriekapazität auf 80% ihres anfänglichen Wertes bzw. ihres Gesamtwertes fallen und somit den sogenannten C80-Zustand erreichen wird. Diese Schätzung dient somit als ein Indikator für die Restlebensdauer der Antriebsbatterie 104. Alternativ oder zusätzlich kann eines der Sub-ML-Modelle ein zweites Schätzer-Modell umfassen, welches die Alterungsrate der Antriebsbatterie 104 für Fahrzeuge abschätzt, bei denen der C80-Zustand noch nicht erreicht ist. Eine Zusammenführung der beiden obigen Sub-ML-Modelle ist dazu in der Lage, eine besonders zuverlässige SOH-Vorhersage unabhängig von aktuellem Fahrzeugzustand und verfügbaren Daten zu treffen.

Das ML-Modell bzw. das ML-Modul 216 ist alternativ oder zusätzlich zum Transferlernen ("transfer learning") ausgebildet. Mittels des Transferlernens ist das ML-Modell dazu in der Lage, basierend auf eingegebenen OBD-Messdaten eines ersten Fahrzeug- und/oder Batterietyps einen oder mehrere Parameterdatensätze (etwa betreffend Kapazität und/oder Innenwiderstand) eines zweiten Fahrzeugund/oder Batterietyps zu generieren. Dies erfolgt vorzugsweise dadurch, dass der Fahrzeug- und/oder Batterietyp als einer der Parameter ins zum Transferlernen trainierte ML-Modell eingegeben wird (bzw. dass die ersten und zweiten Fahrzeugund/oder Batterietypen ins zum Transferlernen trainierte ML-Modell eingegeben werden). Das ML-Modell ist insbesondere durch das Trainieren auf Transferlernen dazu ausgebildet, eine Anpassung der Parameterdatensätze des ersten Fahrzeugund/oder Batterietyps basierend auf einen Unterschied zwischen beiden Fahrzeug- bzw. Batterietypen durchzuführen. Dazu kann eine Look-Up-Table (LUT) oder eine andere Datenbank herangezogen werden, in der Anpassungsfaktoren zwischen dem ersten Fahrzeug- bzw. Batterietyp und dem zweiten Fahrzeug- bzw. Batterietyp vordefiniert sind. Auf diese Weise ist möglich, eine Analyse und/oder Diagnose der aktuellen Antriebsbatterie 104 mit hinreichender Genauigkeit durchzuführen, selbst wenn lediglich auf einen von der aktuellen Antriebsbatterie 104 verschiedenen Batterietypen bezogene und somit limitierte OBD-Messdaten verfügbar sind.

Das ML-Modell bzw. das ML-Modul 216 ist alternativ oder zusätzlich dazu ausgebildet, eine Wahrscheinlichkeitslogik ("probabilistic logic" oder "probabilistic reasoning") zu involvieren. Die Wahrscheinlichkeitslogik wird insbesondere dazu verwendet, Konfidenzintervalle hinsichtlich der erzeugten Parameterdatensätze (etwa betreffend Kapazität und/oder Innenwiderstand), insbesondere durch Berücksichtigung von Unsicherheiten bzw. Toleranzen in den OBD-Messdaten und/oder im ML-Modell/ML-Modul 216 zu ermitteln. Hierzu werden bevorzugt Bayesianische neuronale Netzwerke eingesetzt, die basierend auf der Qualitätsund/oder Vollständigkeitsstufe der OBD-Messdaten Einsichten in die Unsicherheit der Vorhersage über die Restlebensdauer der Antriebsbatterie 104 bieten und für eine solche Vorhersage somit besonders geeignet sind.

Das algorithmische Modell, insbesondere das NN- bzw. ML-Modell, kann außerdem einen Feedback-Mechanismus umfassen, um die Erzeugung der Parameterdatensätze, die Ermittlung der Zustandskennzahl und/oder eine Alterungsprognose kontinuierlich hinsichtlich Genauigkeit zu optimieren. Der Feedback-Mechanismus kann alternativ oder zusätzlich dazu ausgestaltet sein, das ML-Modell/das ML-Modul 216 anhand von realen Daten ("Real World Data") bzw. basierend auf Vergleichsergebnisse mit realen Daten anzupassen, wobei das ML-Modell/das ML-Modul 216 optional mit Parameterdatensätzen (etwa betreffend Kapazität und/oder Innenwiderstand der Antriebsbatterie 104), die mit dem angepassten ML-Modell/ML-Modul 216 gewonnen sind, erneut zu trainieren.

Die auf diese Weise ermittelte Zustandskennzahl wird über eine zweite Kommunikationsschnittstelle 26, die als Datenausgang des Steuersystems 10 fungiert, an eine externe Entität, etwa das Steuergerät 108 des Fahrzeugs 100, ausgegeben werden (entsprechend einem weiteren Verfahrensschritt 208 aus Fig. 9A), um beispielsweise einen Kapazitätsausgleich zwischen den Batteriemodulen/- zellen (Battery Balancing) zu ermöglichen. Alternativ oder zusätzlich kann die ermittelte Zustandskennzahl an ein Anzeigegerät eines Mobilgerätes ausgegeben werden, um das Ergebnis der Batterieanalyse und -diagnose zu visualisieren. Je nach Größe der ermittelten Zustandskennzahl kann die Visualisierung unterschiedlich erfolgen. Beispielsweise kann ein hervorhebender visueller Effekt im Fall eines Überschreitens einer vordefinierten Schwelle durch die Zustandskennzahl bereitgestellt werden. Diese Visualisierung kann zusätzlich in Kombination mit einem Audiosignal automatisiert werden. Auf diese Weise kann der Nutzer des Mobilgerätes den Einsatzzustand der Antriebsbatterie 104 in Echtzeit verfolgen und bei Anomalien oder in kritischen Situationen rechtzeitig Gegenmaßnahmen ergreifen.

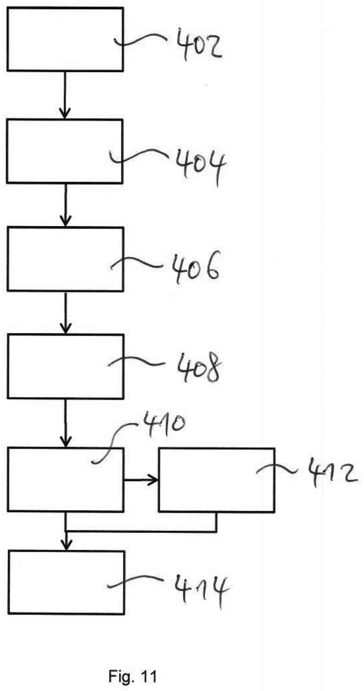

Wie in Fig. 11 schematisch und rein beispielhaft gezeigt, kann das Verfahren ferner Schätzen eines Alters, einer Alterungsrate und/oder einer Restlebensdauer der Antriebsbatterie 104 basierend auf der ermittelten Zustandskennzahl umfassen (entsprechend dem Verfahrensschritt 412 in Fig. 11). Die Verfahrensschritte 402, 404, 406, 408, 410, 414 aus Fig. 11 entsprechen jeweils den in Fig. 10 gezeigten Verfahrensschritten 302, 304, 306, 308, 310, 312 in einer Eins-zu-Eins-Entsprechung. Zwecks der Schätzung wird die ermittelte Zustandskennzahl an ein Schätzungsmodul (hier nicht gezeigt) des Steuersystems 10 ausgegeben, welches hierauf basierend das Alter, die Alterungsrate und/oder die Restlebensdauer der Antriebsbatterie 104 berechnet. Hierdurch wird das Resultat der Batterieanalyse- und Diagnose um eine Alterungsprognose erweitert bzw. vervollständigt. Des Weiteren zeigt Fig. 11 mehrere mögliche Datenpfade: eine erste Option, bei der keine Alterungsprognose durchgeführt und die ermittelte Zustandskennzahl ausgegeben wird (der zugehörige Datenpfad verläuft "vertikal" und nicht über den Verfahrensschritt 412); und eine zweite Option, bei der die Alterungsprognose basierend auf der ermittelten Zustandskennzahl durchgeführt wird, wobei das Resultat der Alterungsprognose entweder nach der Ausgabe der Zustandskennzahl oder gleichzeitig dazu ausgegeben wird (der zugehörige Datenpfad verläuft zweischienig sowohl "vertikal" als auch über den Verfahrensschritt 412).

Erfindungsgemäß wird ein intelligentes Batterieanalyse und -diagnoseverfahren bewerkstelligt, bei dem ausschließlich OBD-Messdaten herangezogen werden. Ein Zugriff auf zusätzliche Sensorik ist somit nicht erforderlich, um den Einsatzzustand der Antriebsbatterie 104 zu bestimmen. Insbesondere entfällt hierdurch die Notwendigkeit, Daten von Ladestationen bzw. Ladesäulen herzuziehen und zu analysieren, sodass die Anzahl der involvierten Datenschnittstellen reduziert wird. Dies führt zur erhöhten Sicherheit und Fehlerbeständigkeit der Batterieanalyse- und Diagnose.

### Bezugszeichenliste

- 10: Steuersystem
- 12: OBD-System
- 14: Ladeeinrichtung
- 16: Startsignal
- 18: Triggersignal
- 20: erste Kommunikationsschnittstelle
- 22: Auswertemodul
- 24: Ermittlungsmodul
- 26: zweite Kommunikationsschnittstelle
- 28: Triggermodul
- 30: Startmodul
- 100: zumindest teilweise elektrifiziertes Fahrzeug
- 102: Elektromotor
- 104: Antriebsbatterie
- 106: DC/AC-Wechselrichter
- 108: Steuergerät
- 110: Hinterachse
- 112: Getriebe
- 114: Hinterräder
- 202-208: Verfahrensschritte
- 210: Eingangsmodul
- 212: Datenbereinigungsmodul
- 214: Vorprozessierungsmodul
- 216: Machine-Learning-Modul
- 218: erstes Teilmodul
- 220: zweites Teilmodul
- 222: Ausgangsmodul
- 302-312: Verfahrensschritte
- 314: Quereinflussinformation
- 402-414: Verfahrensschritte

## Patentansprüche

1. Verfahren zur Ermittlung eines Einsatzzustands einer Batterie (104) eines zumindest teilweise elektrifizierten Fahrzeugs (100), umfassend:
- Erhalten von On-Board-Diagnose-Messdaten, OBD-Messdaten, des Fahrzeugs (100) über eine erste Kommunikationsschnittstelle (20), wobei die OBD-Messdaten während eines elektrisch angeregten Zustandes der Batterie (104) erzeugt sind;
- Auswerten der OBD-Messdaten, um einen Parameterdatensatz zu zumindest einem Betriebsparameter der Batterie (104) zu erzeugen;
- Ermitteln einer Zustandskennzahl der Batterie (104) aus dem Parameterdatensatz, wobei die Zustandskennzahl einen Einsatzzustand der Batterie (104) charakterisiert.

2. Verfahren nach Anspruch 1, wobei zur Erzeugung des Parameterdatensatzes zum zumindest einen Betriebsparameter der Batterie (104) ausschließlich die OBD-Messdaten ausgewertet werden, und/oder wobei zur Ermittlung der Zustandskennzahl der Batterie (104) ausschließlich der erzeugte Parameterdatensatz herangezogen wird.

3. Verfahren nach einem der vorhergehenden Ansprüche, wobei die Auswertung der OBD-Messdaten und/oder die Ermittlung der Zustandskennzahl unter Verwendung eines algorithmischen Modells, vorzugsweise eines neuronalen Netzwerkmodells, insbesondere eines Machine-Learning-Modells, erfolgen.

4. Verfahren nach Anspruch 3, wobei das Machine-Learning-Modell:
- als ein gemischtes Machine-Learning-Modell ausgebildet ist, welches mehrere untergeordnete Sub-Modelle umfasst;
- zum Transferlernen ausgebildet ist; und/oder
- eine Wahrscheinlichkeitslogik involviert.

5. Verfahren nach einem der vorhergehenden Ansprüche, wobei der zumindest eine Betriebsparameter eine Kapazität und/oder einen Innenwiderstand der Batterie (104) umfasst, wobei die OBD-Messdaten dazu ausgewertet werden, um für die Kapazität und/oder den Innenwiderstand der Batterie (104) jeweils einen zugehörigen Parameterdatensatz zu erzeugen.

6. Verfahren nach einem der vorhergehenden Ansprüche, wobei eine Quereinflussinformation (314) bei der Auswertung der OBD-Messdaten und/oder der Ermittlung der Zustandskennzahl berücksichtigt wird.

7. Verfahren nach Anspruch 6, wobei die Quereinflussinformation (314) zumindest eine der folgenden Informationen umfasst: eine Temperatur und/oder eine Temperaturverteilung der Batterie (104) und/oder des Fahrzeugs (100), eine Fahrzeugmodellinformation des Fahrzeugs (100), eine Laufleistung/ein Kilometerstand des Fahrzeugs (100), ein geografischer Standort des Fahrzeugs (100), vorbestimmte Alterungswerte wie Alterungsrate der Batterie (104), OBD-Messdaten vergleichbarer Batterietypen, Temperaturänderungen/-schwankungen während der OBD-Messung, ein und/oder ein Batteriemanagementsystem(BMS)-Parameter.

8. Verfahren nach einem der vorhergehenden Ansprüche, ferner umfassend Schätzen eines Alters, einer Alterungsrate und/oder einer Restlebensdauer der Batterie (104) basierend auf der ermittelten Zustandskennzahl.

9. Verfahren nach einem der vorhergehenden Ansprüche, wobei das Verfahren zumindest teilweise mittels eines Rechenmoduls (22, 24, 28, 30), die einem Server, insbesondere einem Cloud-Server, zugehörig ist, ausgeführt wird.

10. Steuersystem (10) zur Ermittlung eines Einsatzzustands einer Batterie (104) eines zumindest teilweise elektrifizierten Fahrzeugs (100), wobei das Steuersystem (10) dazu ausgebildet ist, das Verfahren nach einem der vorhergehenden Ansprüche auszuführen.

11. Steuersystem (10) nach Anspruch 10, wobei das Steuersystem (10) zumindest teilweise, vorzugsweise vollständig, auf einem Mobilgerät, beispielsweise einem Smartphone und/oder einem Tablett, welches weiter vorzugsweise einen TouchScreen aufweist, bereitgestellt ist.

12. Zumindest teilweise elektrifiziertes Fahrzeug (100), umfassend ein Steuersystem (10) nach Anspruch 10 oder 11.

13. Computerlesbares Speichermedium, umfassend Befehle, die bei der Ausführung durch einen Computer diesen veranlassen, die Schritte des Verfahrens nach einem der Ansprüche 1 bis 9 auszuführen.
